# EUROPEAN PATENT APPLICATION

(11) **EP 4 783 454 A1**
(43) Date of publication of application: **29.07.2026**
(21) Application number: 25382044.3
(22) Date of filing: 24.01.2025
(51) Int. Cl.: H02S 20/22, H02S 20/26, H02S 40/36, H10F 19/00

(54) **INCLINED RAILING WITH ENERGY-GENERATING SOLAR PANELS**

(71) Applicant: Fabricacion de Carpintería de Aluminio Exclusiva Para el Profesional, S.L., 08110 Montcada I Reixac Barcelona (ES)
(72) Inventor: LLUMBIARRES MOSTEIRIN, CARLOS, 08013 BARCELONA (ES)
(74) Representative: Espiell Gomez, Ignacio

(57) **Abstract**

An inclined railing with energy-generating solar panels includes an inclined fixing structure (1) made of metal profiles, either aluminium or steel, along with fittings and joints. Solar panels (2), such as photovoltaic panels for generating electrical energy or hybrid panels for cogenerating photovoltaic and thermal energy, are attached to this structure. The structure features multiple anchors (25) that are spaced apart and secured to the construction. The railing structure (1) is attached to these anchors, and the solar panels (2) are mounted at an angle relative to the horizontal plane of the construction. Additionally, there is at least one skirting board (26) composed of profiles that create a hollow space inside, where the wiring (13) and possibly hydraulic tubes for the solar panels (2) run. This space is accessible through a cover plate (27).

## Description

### OBJECT OF THE INVENTION

The invention, as expressed in the title of this descriptive memory, refers to an inclined railing with energy-generating solar panels that provides, to the function for which it is intended, advantages and characteristics, which are described in detail later, that represent an improvement over the current state of the art.

The object of the present invention lies in a railing, applicable for installation in any structure, such as a construction, for example on a balcony of a home, a roof terrace or in any other existing unevenness in a construction, or a means of transport for both people and goods, such as a boat, which is distinguished, essentially, by comprising a structure of variable inclination, formed mostly by metal profiles, aluminium or steel, fittings and joints, where it incorporates, integrated and secured in it, solar panels; for example, photovoltaic solar panels for the generation of electrical energy and/or hybrid panels for the cogeneration of photovoltaic and thermal electrical energy, providing, among other advantages, the optimisation of solar energy generation, thanks to the adaptation of the inclination based on the orientation and latitude where the railing is located and thanks to the large surface area of the panel, which reaches directly to the handrail, as well as greater robustness of the panel anchoring system, as it is secured both at its lower and upper parts, and therefore greater safety compared to other currently known systems.

### SCOPE OF APPLICATION OF THE INVENTION

The scope of application of this invention is framed in the construction sector, focusing particularly on the field of railings construction, at the same time covering the field of manufacture and installation of solar energy generating panels, both photovoltaic and hybrid panels.

### BACKGROUND OF THE INVENTION

As it is known, the trend in construction is the implementation of renewable energy systems, so it is increasingly common to install solar panels for the generation of energy, usually photovoltaic or thermal, although in recent years the use of so-called 'hybrid' panels has increased, which use both technologies.

These panels, although they are usually installed mostly on roofs and terraces, are also known to be installed on balconies so that they can be used by inhabitants of apartment blocks. The installation of solar panels on balconies is interesting for those buildings where installation on the roof is not possible or simply when a user wants to install solar panels for private use, avoiding the need for it to be communal. However, the fact of implementing a solar panel with little or no transparency leads to a general rejection by the end user, which is why roofs and terraces continue to be the place where photovoltaic installations in non-integrated constructions (BAPV), Building Applied Photovoltaic are mostly used, while the railing object of the invention proposes to free up said space on the terraces through architectural integration (BIPV), Building Integrated Photovoltaics, on their perimeter.

On the other hand, most of the solar panels that are installed on balconies and railings are fixed to these on their conventional structure, which can pose a risk if they are not well secured or if the structure is not designed to support the extra weight that the panels entail.

Furthermore, in most cases, balcony railings are vertical, so the panels are either fixed in a vertical position, which means that the incidence of radiation is never optimal, or they are fixed on additional structures to place them in an inclined position, with the consequent increase in the cost of the installation, and more importantly, the increase in weight that this structure entails.

Although not currently on the market, there are some patents that disclose inclined railings with solar panels.

For example, patents FR2934623A1, EP2317245A1 and JP2002121874A disclose a railing with uprights forming an angle with respect to the vertical.

None of the identified precedents proposes a solution for hiding the cables and/or hydraulic tubes of the solar panels within the railing structure itself to improve user safety, and there is not a solution facilitating access to said cables or hydraulic tubes to simplify their repair.

None of the identified precedents proposes additional elements that improve the robustness of the inclined solar railing, such as vertical posts, the use of two or more pilasters per solar panel and securing it both at its upper and lower ends.

None of the identified precedents proposes the use of a handrail that maintains ergonomics regardless of the inclination of the solar panel.

Furthermore, none of the identified precedents allows sufficient universality to meet the technical requirements (inclinations of the solar panel, form of anchoring of the structure, adaptation to corner angles), as well as visual requirements (minimalist style or classic style) of most architectural projects.

The objective of the present invention is, therefore, the development of an inclined railing that resolves said problems in a practical and effective manner.

### EXPLANATION OF THE INVENTION

The inclined railing with energy-generating solar panels proposed by the invention is configured as an ideal solution to achieve the aforementioned objectives, while representing an improvement on the current state of the art. The characterising details that make this possible and that conveniently distinguish it are included in the final claims accompanying this description.

An inclined railing should be understood as a BIPV (building integrated photovoltaics) system, a structural element permanently integrated into the construction (not superimposed) with a dual purpose: architectural (fall protection, solar protection, part of the building envelope, ...) and renewable energy generation.

The railing object of the invention allows the solar panel to be placed vertically and/or with very pronounced inclinations, thus enhancing greater energy generation and adapting to the optimal inclination according to the orientation and latitude of the construction. The inclined solar railings known so far do not allow the panel to be placed vertically because the height of the railing would exceed the commonly accepted height for such use.

The energy generated by the railing object of the invention can be used both for self-consumption and for introduction into the general energy network (electricity and hot water).

The railing object of the invention allows not only the use of photovoltaic solar panels but also hybrid panels (photovoltaic and thermal) as well as bifacial photovoltaic panels. In both cases, relevant technical improvements are proposed: adaptation to the different flow rates required by the construction, use of liquid with antifreeze properties, and horizontal elements reflecting sunlight.

Specifically, as previously mentioned, the invention proposes an inclined railing with energy-generating solar panels that comprises an inclined fixing structure, formed by metal profiles, made of aluminium or steel, fittings and joints, to which solar panels (2) are attached, for example, photovoltaic panels to generate electrical energy and/or hybrid panels to cogenerate photovoltaic and thermal electrical energy, which is distinguished by comprising:
- a plurality of separate anchors fixed to the construction, where the railing structure is attached and, in turn, the solar panels are attached in an inclined manner with respect to the horizontal plane of the construction, and
- at least one skirting board formed by a set of profiles creating a hollow space inside where the wiring runs, and possibly the hydraulic tubes, of the solar panels and accessible through a cover plate.

This configuration of the inclined railing with solar panels allows for easy and quick installation and repair of the wiring system, and possibly the hydraulic system, of the solar panels.

The anchors can consist, for example, of bases where a plurality of inclined pilasters are attached and in turn the solar panels, or base supports provided with shims and joints configured to hold the solar panel in an inclined position.

In a first version of the invention, the structure of the inclined railing comprises:
- a plurality of base-shaped anchors fixed to the construction on or in front of the slab where a plurality of inclined pilasters are attached,
- a lower support profile fixed to the inclined pilasters,
- an upper handrail fixed to the inclined pilasters, and parallel to the lower support, and
- a skirting board in the form of an intermediate skirting board profile attached to the inclined pilasters
with the solar panel being held by the lower support profile and by the upper handrail in such a way that, when removing the handrail, it is possible to disassemble the solar panel, without the need to remove any additional profile and in such a way that when removing the lower skirting board profile, access to the wiring is provided.

The use of bases offers greater universality of the railing since it can be anchored on or in front of any surface.

The inclined pilasters can be formed, for example, by curved profiles and/or by cut and welded profiles to achieve the desired inclination, or by straight profiles fixed at an incline to the base. In this case, the shape of the base allows the inclination of the system, thanks to which an optimisation of energy generation is achieved (thanks to the optimal inclination required), a cost optimisation (unifying elements and modifying their shape to achieve the optimal inclination required) and greater robustness (the unification of elements avoids risks of inadequate machining and therefore improves the safety of the system) and, with it, greater safety.

The bases anchored to the construction may include means for selecting the inclination at which the pilasters (3) will be fixed after the railing installation.

This version is interesting for adjusting the inclination of the solar panels after the installation of the bases to optimise energy generation.

In a second version of the invention, the structure of the inclined railing comprises:
- A plurality of anchors in the form of separate base supports anchored to the construction, provided with shims and joints configured to support the solar panel at its lower part with a specific inclination between 65° and 89.99° with respect to the horizontal plane of the construction.
- A skirting board in the form of a lower skirting board profile that includes a removable exterior cover profile, which joins and covers the supports,
this allows the solar panel to be dismantled and to access the wiring when the exterior cover is removed.

Optionally, the inclined railing with solar panels includes a handrail made with a substantially round section profile with a groove where the solar panels fit and, eventually, where the inclined pilasters also fit. This configuration allows for greater universality and ergonomics by maintaining the same comfort for the user, regardless of the inclination applied to the railing.

On the other hand, in an optional version, the solar panels of the railing are bifacial photovoltaic panels, i.e., suitable for generating photovoltaic energy on both sides of the panel.

The use of bifacial photovoltaic panels allows optimising electrical energy generation and improves the aesthetics of the product by generating design uniformity and greater adaptability to the aesthetic requirements of the construction.

When the photovoltaic solar panels are bifacial, the inclusion of reflective elements is optionally considered, capable of increasing solar incidence on one side of said bifacial panel, increasing its productivity. Preferably, these elements will be flat elements placed on the ground below the bifacial solar panel, where the user will presumably be located, and which may also have non-slip properties. This achieves an optimisation of energy generation.

In one version of the invention, when the railing has corners, the profile structure is designed to form closed or acute angles from 40° to 89.99°, thus allowing the electrical wiring to continue passing through its interior.

In this version, the solar panels should preferably have special shapes, adapted to the inclination and angle of the corner-forming structure, so that it is not necessary to add new elements to the corners of the railing system, as the panels themselves ensure the absence of gaps large enough to compromise people's safety.

Alternatively, instead of solar panels with special shapes, it is planned to incorporate glazing adapted to the inclination and angle (α) of the corner-forming structure, allowing for improved aesthetics by maintaining design uniformity, protecting the gap according to regulations, and avoiding the need to customise the panel for corner junctions.

In one version of the invention, when the railing panels are hybrid, i.e., capable of generating both photovoltaic and thermal energy, the preferred support structure is the variant comprising inclined pilasters, handrails, lower support profile, and intermediate skirting boards. This structure is specially adapted to integrate such panels and their functional components, including elements such as hydraulic inlet and outlet, incoming liquid connections to the panel, outgoing hot liquid connections, and longitudinal pipes, as well as a common collector that conducts the wiring and tubes towards the interior of the construction.

Hybrid panels generate thermal energy while optimising photovoltaic energy generation due to less panel overheating, leading to an excellent improvement in overall panel efficiency - close to 70% and 80% instead of the 20% generally achieved through monocrystalline photovoltaic technology.

Furthermore, the piping system and photovoltaic layer of these hybrid panels can be installed in different ways: integrated into the same panel laminate, integrated into the rear of the panel laminate, or integrated into the front of the panel laminate between the laminate and the inclined pilasters.

This allows the railing to provide optimised energy generation, as the production of thermal energy and the optimisation of photovoltaic energy due to less panel overheating leads to an excellent improvement in overall panel efficiency - close to 70% and 80% - instead of the 20% generally achieved through monocrystalline photovoltaic technology.

In a preferred version of the invention, when it includes hybrid solar panels, the structure of the inclined railing comprises:
- a hydraulic inlet for ambient temperature liquid and a hydraulic outlet for hot liquid through the lower part of the inclined pilasters
- for each group of panels, a pipe parallel to the pilaster profile, to elevate the incoming ambient temperature liquid towards a longitudinal pipe located inside the upper handrail profile;

- incoming liquid connections to the panel located in the upper handrail profile;
- the piping system and photovoltaic layer, forming part of the panel, secured between the lower support profiles and upper handrail;
- outgoing hot liquid connections to the panel located between the inclined pilasters and the panel;
- outgoing hot liquid conduction pipes from the outgoing liquid connection to the lower skirting board profile;
- longitudinal pipes containing hot liquid, located in the lower skirting board profile; and
- a common collector that conducts the wiring and tubes towards the interior of the construction.

This configuration of the inclined railing structure increases user safety and comfort, as placing ambient temperature pipes inside the handrail, instead of hot liquid pipes, prevents high temperatures from being transmitted to the user.

The hybrid solar panels can have the same thickness across their entire surface, so that the upper handrail and lower support profile must have sufficient depth and glazing capacity to allow the coupling of the hybrid solar panel.

Alternatively, the hybrid solar panels can have a greater thickness in the central part where the piping system is located, either on the front or back, compared to the lower and upper areas of the panel (2), where there is a smaller thickness to facilitate the fitting of the panel (2) between the lower support profiles (9) and upper handrail (5).

Solar panels are generally rectangular and can therefore be arranged either horizontally or vertically in the structure of the inclined railing to optimise energy generation thanks to the larger panel surface per linear meter of railing.

In one version of the invention, each solar panel is held by two inclined pilasters, one on each side of the panel, or by three inclined pilasters, two lateral and one central.

This version allows the solar panels to be placed at an inclination between 30 and 85° with respect to the horizontal plane of the construction, and consequently place the solar panels both horizontally, i.e., so that their width (a) is greater than their height (h), and vertically, such that their height (h') is greater than their width (a').

Optionally, each inclined pilaster is supported by at least one vertical post located between its lower end and the handrail, or by at least two vertical supports, one located closer to the lower end and the other closer to the handrail.

This version allows the solar panels to be placed at an inclination between 30 and 85° with respect to the horizontal plane of the construction, and consequently place the solar panels both horizontally, i.e., so that their width (a) is greater than their height (h), and vertically, such that their height (h') is greater than their width (a').

In one version of the invention, the profile structure of the railing is mostly hollow and designed to allow total concealment of the electrical wiring by locating it inside, particularly inside the handrail, the lower skirting board, and the inclined pilasters, which will be conveniently machined for this purpose, allowing the entry and exit of said electrical wiring.

In one version of the invention, both the handrail and the skirting board are formed by profiles that have a cover profile fixed with clips that allows access to the wiring by disassembling it, enabling periodic review of the wiring system and other protective means, such as corrugated tubes, insulators, connections to micro-inverters, common collectors or fault switches or AFCI (Arc Fault Circuit Interrupter) and GFCI (Ground Fault Circuit Interrupter) circuit breakers, providing greater repairability, thanks to the time savings of this system, and greater safety, thanks to being able to identify and resolve incidents as quickly as possible and, if necessary, isolate part of the damaged system from the rest of the system so that it continues to function, which leads to lower maintenance costs.

In one version of the invention, the railing structure includes various insulating elements between it and the solar panel, mainly joints, shims, and rubber components, which eliminate electrical conductivity between the panel and the metal profiles, providing safety by reducing the risk of electric current transmission to the user and deterioration of the materials that make up the railing.

Furthermore, in the variant with separate support profiles to hold the panel, the fact that these supports are separated from each other also prevents electrical conductivity through the entire railing system should other safety measures fail.

In one version of the invention, the structure is preferably configured to integrate, hidden within it, the micro-inverters and/or circuit breakers, accessible through a specially designed cover to facilitate access to them and ensure proper ventilation, avoiding overheating in cases of network voltage overloads. This feature also provides the railing with greater repairability, thanks to easy access to micro-inverters, and greater safety, thanks to being able to identify and resolve incidents as quickly as possible and, if necessary, isolate part of the damaged system from the rest of the system so that it continues to function, which leads to lower maintenance costs.

Additionally, and also preferably, when the electrical wiring is not protected by being located inside the structure profiles and it is exposed to the exterior in specific areas, it is protected by corrugated tubing for greater safety. Thanks to increased protection, the risk of electrical conduction to the metal elements of the railing is reduced and it avoids erosion from weather conditions and rodents.

The railing object of the invention may also include the necessary ground connections to ensure electrical dispersion in case of an accident.

Likewise, as safety elements, the system may include the placement of arc fault interrupters or AFCI and GFCI type circuit breakers along the electrical circuit.

The solar panels of the invention's railing are susceptible to including, on their external surface, aesthetic customisation on the part that is visible from the construction using techniques such as screen printing or the application of tints in the glazed layers of the panel, thus achieving a better aesthetic of the product, thanks to a uniformity of design and greater adaptability to the aesthetic requirements of the construction.

Finally, in one optional version, the railing may include the placement of LED lighting incorporated in the lower or upper part of the solar panel, between it and the structure profile to which it is fixed, powered by the photovoltaic energy generated itself, providing a better aesthetic.

### DESCRIPTION OF THE DRAWINGS

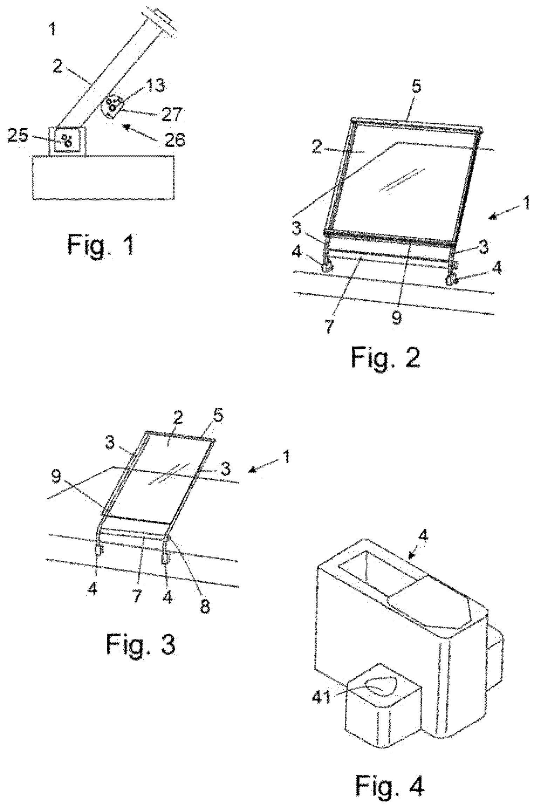

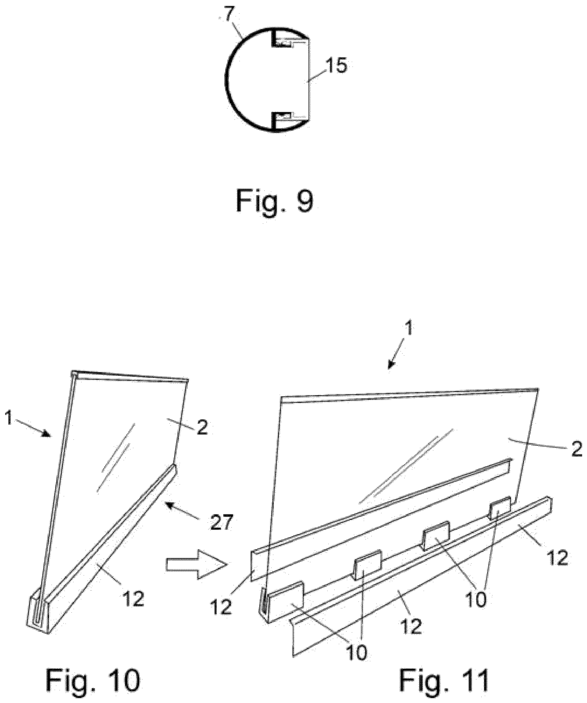

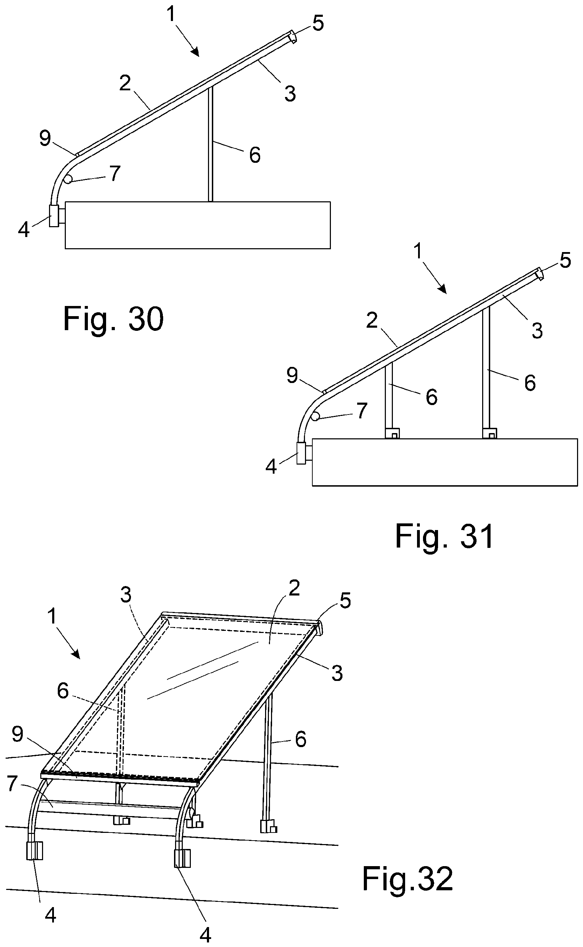

To complement the description being made and with the aim of helping to better understand the characteristics of the invention, this descriptive memory is accompanied, as an integral part of it, by a sheet of drawings in which, for illustrative and non-limiting purposes, the following has been represented:
Figure number 1.- Shows a schematic side elevation view of an example of the inclined railing object of the invention, showing the basic elements it comprises and their arrangement.
Figures number 2 and 3.- Show respective perspective views of two examples of the inclined railing, in this case with pilasters for fixing by means of bases on the slab of the construction and in front of the slab, respectively.
Figures number 4 and 5.- Show respective perspective views of two examples of the base on which the inclined pilasters are fixed, in the respective options for fixing, on the slab of the construction and in front of it, shown in figures 2 and 3.
Figure number 6.- Shows a schematic lateral section view of the railing, in its variant with inclined pilasters, showing the location of the electrical wiring inside the profiles.
Figure number 7.- Shows a detail of the perforated pilaster for the insertion of electrical wiring.
Figure number 8.- Shows a schematic view of the disassembly of the upper handrail to extract the panel in a first variant of the railing with pilasters.
Figure number 9.- Shows a sectional view of the intermediate skirting board profile, showing the clip-on cover that allows access to the wiring inside.
Figures number 10 and 11.- Show respective views of the disassembly of the exterior cover profile for the extraction of the solar panel in the second variant of the inclined railing with inclination between 65° to 89.99° and the structure of separate supports and the exterior cover profile.
Figure number 12.- Shows a side elevation view of the railing example shown in figures 10 and 11.
Figure number 13.- Shows a side elevation view of the support of the railing example shown in figures 10 to 12.
Figure number 14.- Shows a sectional view of the handrail, showing its parts.
Figures number 15, 16 and 17.- Show respective side elevation views of a detail of how the inclined pilaster is fixed to the base in three optional versions to adapt the inclination of the pilaster, with curved profile, with cut and welded segments and with inclined union to the base.
Figures number 18-A and 18-B.- Show respective perspective views of two other optional examples of the fixing of the inclined pilaster to the base. In this case, with the possibility of selecting the inclination with which the pilasters (3) will be fixed after the installation of the railing.
Figure number 19.- Shows a perspective view of an example of the railing in its variant with support profiles, in an example with bifacial photovoltaic panel.
Figure number 20.- Shows a schematic side elevation view of another example of the railing, in this case in its variant with inclined pilasters, with bifacial photovoltaic panel and also flat reflective elements.
Figures number 21 and 22.- Show respective front perspective views of the railing in the corner, in their respective variants with lower support and with pilasters.
Figure number 23.- Shows a schematic representation of the railing with hybrid solar panels, showing their conduits.
Figures number 24 and 25.- Show respective schematic sectional views of the arrangement of the elements of the hybrid panel inside the profiles of the railing structure, in respective examples with the piping system and the photovoltaic layer in the same panel laminate, showing the flow direction in opposite options.
Figures number 26 and 27.- Show respective schematic sectional views of the arrangement of the elements of the hybrid panel, in this case, in an option with the tube system and photovoltaic layer above the panel laminate, and in another option with the tube system and photovoltaic layer behind the panel laminate.
Figure number 28.- Shows a perspective view of another example of the inclined railing according to the invention, in its variant of inclination between 30 and 85° with structure of inclined pilasters and vertical supports, specifically an example with three pilasters per panel, two on each side and one central.
Figure number 29.- Shows a perspective view of a railing with two types of fixing of the solar panels, in horizontal position on one side and vertical on the other.
Figures number 30 and 31.- Show respective side elevation views of the example of the railing in the variant of inclination between 30 and 85° with structure of inclined pilasters and vertical supports, specifically an example with each pilaster supported on a vertical support in figure 30 and on two vertical supports in figure 31.
Figure 32.- Shows a perspective view of another example of the inclined railing according to the invention, again in its variant of inclination between 30 and 85° with structure of inclined pilasters and vertical supports, specifically, an example with two lateral pilasters per panel.

### PREFERRED VERSION OF THE INVENTION

As shown in the mentioned figures, and according to the adopted numbering, different non-limiting examples of the inclined railing with energy-generating solar panels of the invention can be observed, which comprises what is described in detail below.

Thus, as shown in figure 1, the inclined railing with energy-generating solar panels object of the invention comprises an inclined fixing structure (1), formed by metal profiles, aluminium or steel, fittings and joints, to which solar panels (2) are attached, for example, photovoltaic panels to generate electrical energy and/or hybrid panels to cogenerate photovoltaic and thermal electrical energy. In turn, the fixing structure comprises:
- a plurality of separate anchors (25) fixed to the construction, where the railing structure (1) is attached and, at the same time, the solar panels (2) are attached in an inclined manner with respect to the horizontal plane of the construction; and
- at least one skirting board (26) formed by a set of profiles creating a hollow space inside where the wiring (13) runs, and possibly the hydraulic tubes, of the solar panels (2) and accessible through a cover plate (27).

In one version of the invention, as seen in figures 2, 3, 6 and 8, the structure of the inclined railing object of the invention comprises:
- a plurality of anchors (25) in the form of bases (4) anchored to the construction on or in front of the slab, where a plurality of inclined pilasters (3) are attached;
- a lower support profile (9) fixed to the inclined pilasters (3);
- a handrail (5) fixed to the inclined pilasters (3), and parallel to the lower support (9); and
- a skirting board (26) in the form of an intermediate skirting board profile (7) attached to the inclined pilasters (3), with the intermediate skirting board (7) accessible through a cover plate (15).

The solar panel (2) is fastened by the lower support profile (9) and by the handrail (5) so that, when the handrail is removed, (5) it is possible to disassemble the solar panel (2), without the need to remove any additional profile and in such a way that when removing the cover plate (15) from the intermediate skirting profile (7), access to the wiring is provided, and it is possible to locate additional wiring (13) inside the lower support profiles (9) and handrails (5).

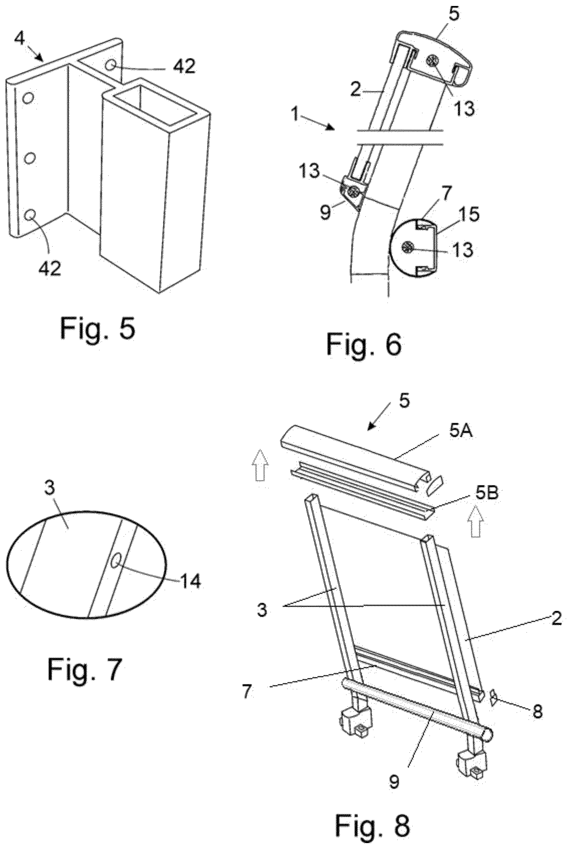

Preferably, the intermediate skirting board (7) is formed by profiles that have a cover profile fixed with clips (15), visible in figure 6, which allows access to the wiring (13) by disassembling it, enabling periodic review of the wiring system and other protective means, such as corrugated tubes, insulators, connections to micro-inverters, common collectors or fault switches or circuit breakers, which are described later.

These bases (4) can have diverse configurations and be designed to be anchored either on the construction slab, for example, having vertical openings (41) for screwing onto the slab (figure 4) or in front of the slab, for example, having horizontal holes (42) for screwing to the front of the slab (figure 5).

Preferably, and as shown in figure 6, inclined pilasters (3), the handrail (5) and intermediate skirting board (7), are designed to allow total concealment of the electrical wiring (13) by locating it inside said hollow profiles, particularly inside the handrail (5), the lower skirting board (7) and the inclined pilasters (3) which will be conveniently machined with perforations (14) made for this purpose, allowing the entry and exit of the electrical wiring (13).

In one version of the invention, the structure of the railing profiles, such as the profiles that form the handrail, the skirting board and the bottom support are hollow and allow the passage and concealment of the wiring and tubes of the solar panels. In this case, preferably, there are cover plates (8) at their lateral ends covering the hollow of the profiles (figure 8).

Optionally, the profiles that form the handrail, the baseboard and the lower support are conveniently machined for this purpose, generating holes (14) that allow the entry and exit of the electrical wiring (figure 7).

In another version of the invention, as shown in Figures 10, 11 and 12, the structure of the inclined railing object of the invention comprises:
- a plurality of anchors (25) in the form of separate base supports (10) anchored to the construction, provided with shims and joints (11) configured to hold the solar panel (2) at its lower part with a specific inclination between 65° to 89.99° with respect to the horizontal plane of the construction;
- a lower skirting board profile (7) that includes a removable exterior cover profile (12), which joins and covers both sides of the base supports (10).

This allows the solar panel (2) to be dismantled and access to the wiring (13) when the exterior cover (12) is removed.

Preferably, the lower skirting board is also configured to allow the disassembly of the exterior cover profile (12) and give access to the wiring, without the need to remove any additional profile, enabling periodic review of the wiring system and protection measures (corrugated tubes, insulators, connections to micro-inverters, common collectors or fault switches or circuit breakers).

In one version of the invention, when the inclined railing includes handrails (5), it is manufactured using an upper profile (5A) with a substantially round section with a groove where the solar panels (2) fit, and eventually where a lower profile (5B) of the handrail fixed to the inclined pilasters (3) also fits in such a way that the handrail (5) is ergonomic regardless of the inclination of the solar panels (12).

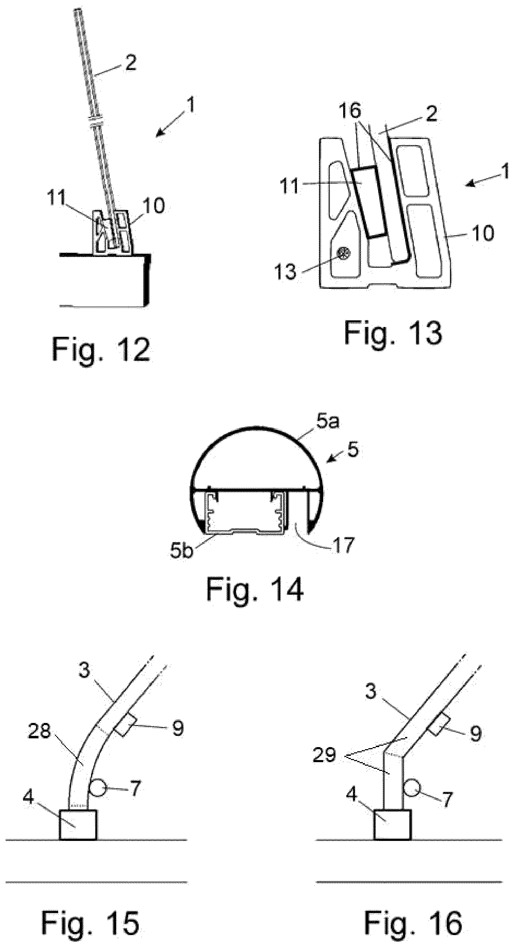

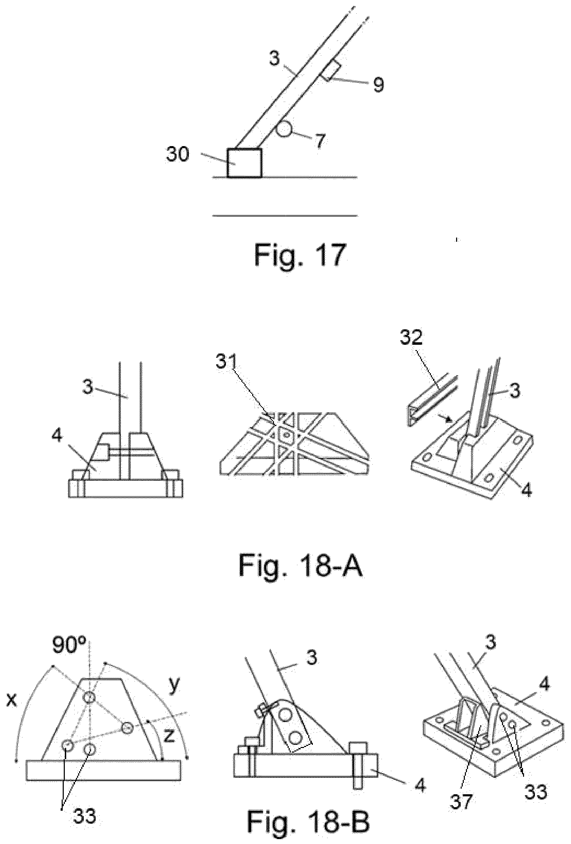

The inclined pilasters (3) can be formed with one of the following elements:
- curved profiles (28) with the desired inclination (figure. 15);
- straight profiles cut and welded (29) between them to achieve the desired inclination (figure 16); or
- a single profile fixed to the stand which gives the desired inclination to the profile (30) (figure 17).

It is also foreseen that the inclined pilasters (3) are formed by a combination of two or more of the previous elements, curved profiles, cut and welded profiles and inclined fixation to the base.

Optionally and as shown in figure 18, the bases (4) include means to select the inclination with which the pilasters (3) will be fixed after the installation of the railing, such as:
- a base (4) with different slots (31) where the pilaster (3) fits with a specific inclination, and an additional tightening element (32); or
- a base with different through holes (33) where it is possible to fix the pilaster (3) with at least two pins and subsequently an additional support element (37).

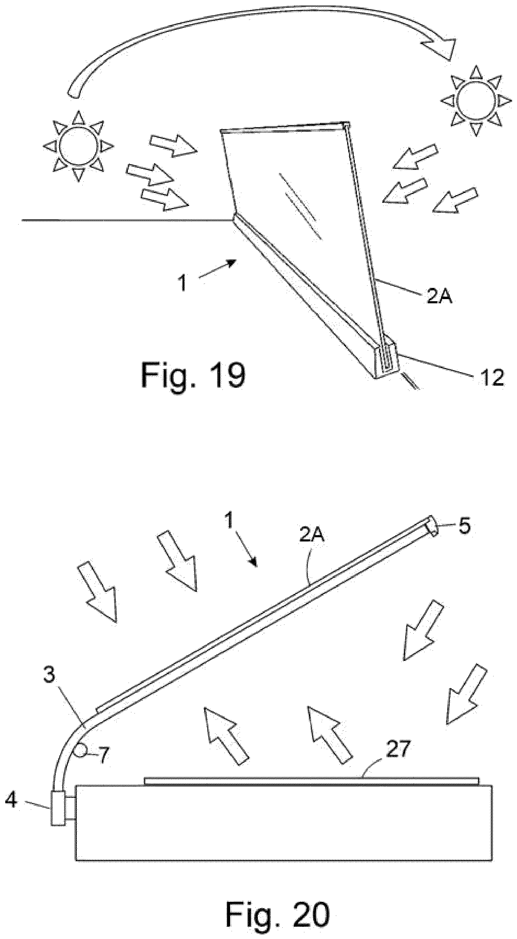

On the other hand, it should be noted that, in one optional version (figure 19), one or more of the solar panels (2) part of the railing (1) are bifacial photovoltaic panels (2A), suitable for generating photovoltaic energy on both sides of the panel.

In such case, preferably and as shown in figure 20, it is also contemplated the inclusion of flat elements (27) placed, as shown in figure 34, on the floor below the bifacial solar panel (2A) where the user will presumably be located, with non-slip and reflective properties, capable of increasing solar incidence on one side of said bifacial panel, increasing its productivity.

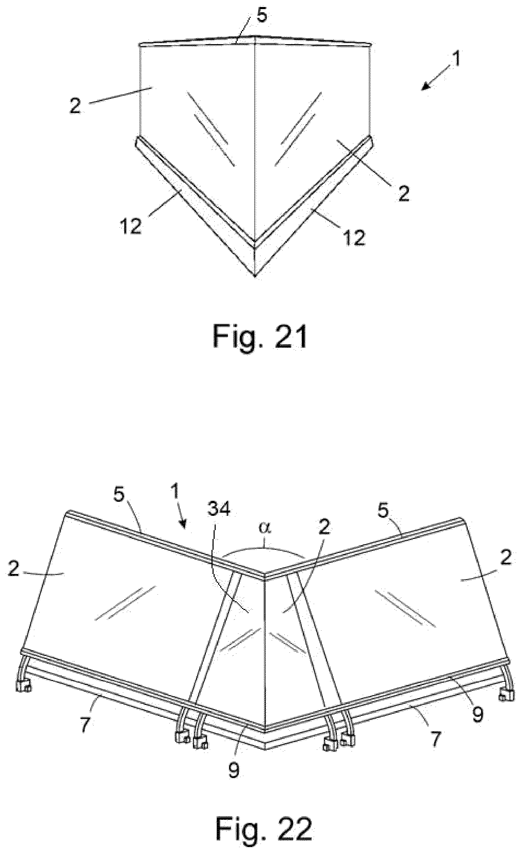

On another note, it should be highlighted that, preferably, the structure of the railing (1), both in the variant comprising lower support profiles (9), lower skirting board (7) and upper handrail (5), and in the variant comprising separate supports (10) covered with the exterior cover profile (12), it is configured so that in both cases the profiles can be found in corners forming closed angles (α) from 40° to 89.99°, thus allowing the electrical wiring (13) to continue passing through its interior. (figures 21 and 22)

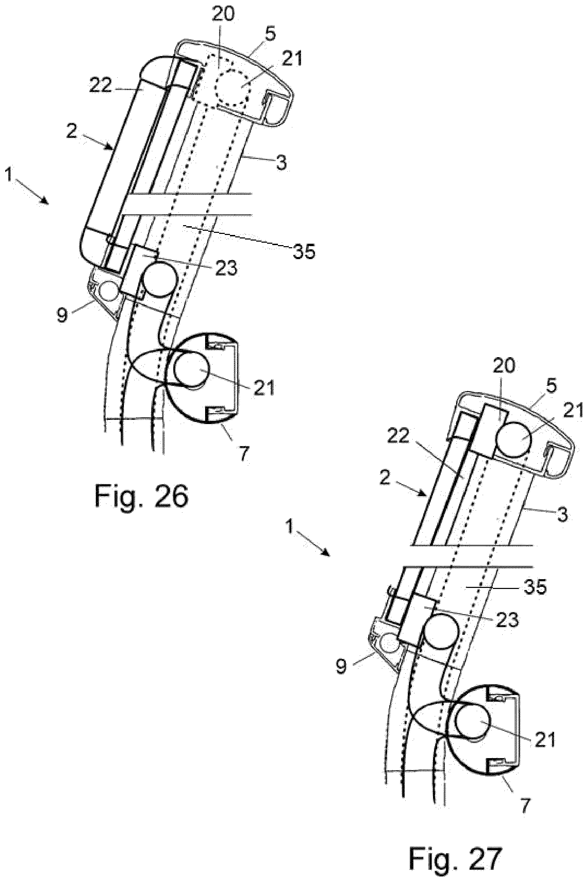

In this version, the railing (1) can have solar panels (2) with customised shapes, adapted to the inclination and angle (α) of the structure forming a corner, as shown in the example in figure 27, thus allowing the gap to be protected according to regulations.

Optionally, the railing (1) can incorporate glazing (34), instead of a solar panel (2) with the described customised shape, adapted to the inclination and angle (α) of the structure forming a corner, allowing the gap to be protected according to regulations and avoiding the need for the panel to be customised for corner junctions.

The solar panels (34) or glazing with customised shapes allow covering and avoid adding new elements in the corners of the railing system, as the solar panels or the glazing with customised shapes would ensure the absence of gaps large enough to compromise people's safety.

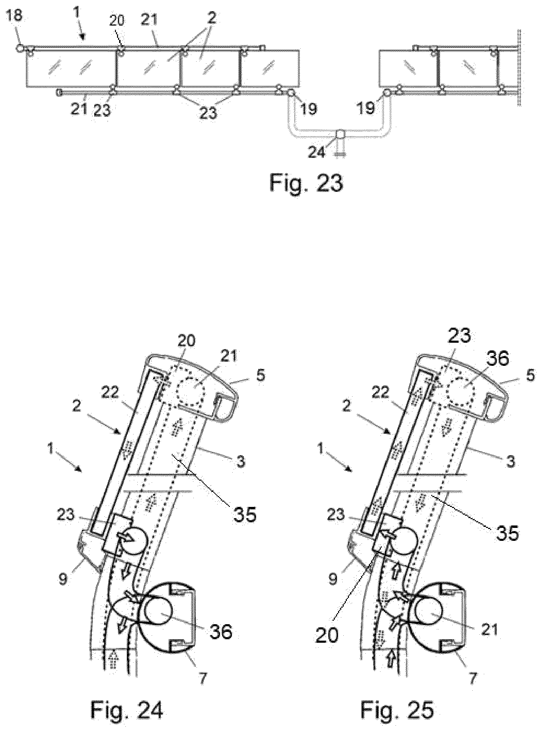

Referring to figures 23, 24, 25 and 27, a version of the inclined railing (1) comprising hybrid solar panels (2), capable of generating photovoltaic and thermal energy, is shown.

In this version of the invention when the inclined railing comprises hybrid solar panels (2), the structure of the railing comprises:
- a hydraulic inlet (18) for ambient temperature liquid and a hydraulic outlet (19) for hot liquid;
- for each group of panels (2), a parallel pipe (35) to the pilaster profile (3), to transport the incoming ambient temperature liquid towards a longitudinal pipe (21);
- incoming liquid connections (20) to the panel (2);
- the piping system and the photovoltaic layer (22), forming part of the panel (2), being held between the lower support profiles (9) and upper handrail (5);
- outgoing hot liquid connections (23) to panel (2);
- hot liquid conduction pipes from the outgoing liquid connection (23) to a hot liquid longitudinal pipe (36);
- longitudinal pipes (36), containing hot liquid towards the hot liquid hydraulic outlet (19); and
- a common collector (24) that conducts the wiring and tubes towards the interior of the construction.

It is possible to direct the hot water flow both from the upper part of the panel towards the lower part (figure 24), and in the opposite direction (figure 25).

Additionally, as shown in figure 23, a common collector (24) that conducts the wiring and tubes towards the interior of the construction is also provided.

In one optional version, shown in figures 23 and 24, the piping system and the photovoltaic layer (22) are integrated into the same panel laminate (2), having the same thickness across its entire surface, between the lower support profiles (9) and upper handrail (5).

In another optional version, shown in figure 26, the piping system and the photovoltaic layer (22) are located in the front part of the area or laminate of the panel (2), allowing it to occupy a greater thickness compared to the thickness of the lower and upper area of the panel (2), as a solution to the limited glazing space allowed by the lower support profile (9) and upper handrail (5), where it will be attached.

And, in another optional version, shown in figure 27, the piping system and the photovoltaic layer (22) are placed in the rear part of the area or laminate of the panel (2), without touching the inclined pilasters (3), allowing it to occupy a greater thickness compared to the thickness of the lower and upper area of the panel (2), as a solution to the limited glazing space allowed by the lower support profile (9) and upper handrail (5), where it is attached.

The solar panels (2), which are generally rectangular in configuration, can be arranged fixed in the railing structure, both in a horizontal position, so that their width (a) is greater than their height (h) as shown in figure 2, and in a vertical position, in which case their height (h') will be greater than their width (a') as shown in figure 3, always respecting the legally required height for a railing (figure 29).

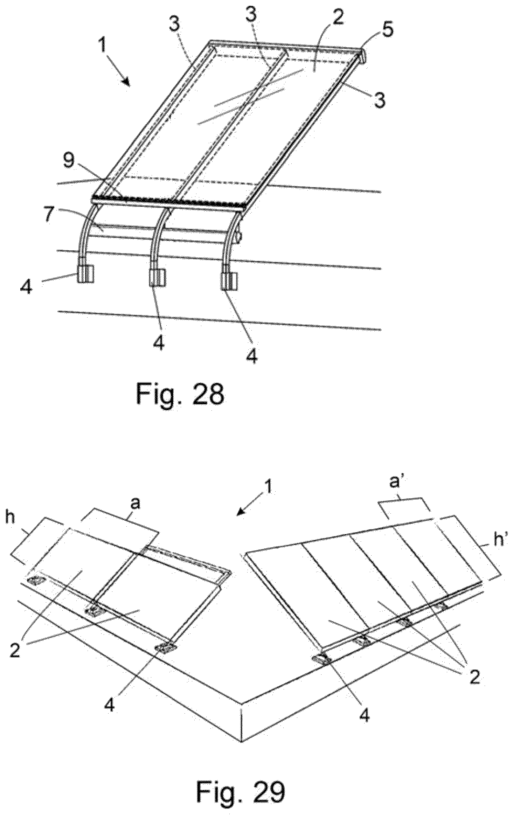

In one version, each solar panel (2) is held by two inclined pilasters (3), one on each side of the panel (2), or by three inclined pilasters (3), two on the sides and one central, as shown in figure 28.

This configuration allows the solar panels (2) to be placed with an inclination of between 30 and 85° with respect to the horizontal plane of the construction and consequently place the solar panels (2) both in a horizontal position, so that their width (a) is greater than their height (h), and in a vertical position, such that their height (h') is greater than their width (a').

In one version, each inclined pilaster (3) is supported on a vertical post (6) located between its lower end and the handrail (5), as shown in figures 28 and 32.

Preferably, the vertical posts (6) are placed with sufficient distance from the handrail (5) so that the user cannot trip over them with their feet.

It is also foreseen that each inclined pilaster (3) can be supported on at least two vertical posts (6) as shown in figure 31, one located closer to the lower end and the other closer to the handrail (5).

This configuration allows the solar panels (2) to be placed with an inclination of between 30 and 85° with respect to the horizontal plane of the construction and consequently place the solar panels (2) both in a horizontal position, so that their width (a) is greater than their height (h), and in a vertical position, such that their height (h') is greater than their width (a').

Preferably, the structure of the railing comprises different insulating elements (16) between it and the solar panel (2), for example, joints, shims and rubbers, which allow eliminating electrical conductivity between the panel (2) and the metal profiles as shown in figure 13.

Furthermore, the fact that the support profiles (10) are separated from each other also prevents electrical conductivity through the entire railing system (1) in case the other safety measures fail.

Having sufficiently described the nature of the present invention, as well as the manner of putting it into practice, it is not considered necessary to make its explanation more extensive for any expert in the field to understand its scope and the advantages derived from it.

## Claims

1. Inclined railing with energy-generating solar panels comprising an inclined fixing structure (1), formed by metal profiles, aluminium or steel, fittings and joints, to which solar panels (2) are attached, for example, photovoltaic panels to generate electrical energy and/or hybrid panels to cogenerate photovoltaic and thermal electrical energy, **characterised by** the composition of its structure:
• a plurality of separate anchors (25) fixed to the construction, where the railing structure (1) is attached and in turn the solar panels (2) are attached in an inclined manner with respect to the horizontal plane of the construction; and
• at least, one skirting board (26) formed by a set of profiles creating a hollow space inside where the wiring (13) runs, and possibly the hydraulic tubes, of the solar panels (2) and accessible through a cover plate (27).

2. Inclined railing with solar panels generators of energy, according to claim 1, **characterised by** the composition of its structure:
• a plurality of anchors (25) in the form of bases (4) anchored to the construction on or in front of the slab where a plurality of inclined pilasters (3) are attached;
• a lower support profile (9) fixed to the inclined pilasters (3);
• a handrail (5) fixed to the inclined pilasters (3), and parallel to the lower support (9); and
• a skirting board (26) in the form of an intermediate skirting board profile (7) attached to the inclined pilasters (3), with the intermediate skirting board (7) being registerable through a cover plate (15).
the solar panel (2) is fastened by the lower support profile (9) and by the handrail (5) so that, when the handrail is removed (5), it is possible to disassemble the solar panel (2) without the need to remove any additional profile and, in such a way, that when removing the cover plate (15) from the intermediate skirting profile (7), access to the wiring is provided, and it is possible to locate additional wiring (13) inside the lower support profiles (9) and handrails (5).

3. Inclined railing with solar panels generators of energy, according to claim 1, **characterised by** the composition of its structure:
• a plurality of anchors (25) in the form of separate base supports (10) anchored to the construction, provided with shims and joints (11) configured to hold the solar panel (2) at its lower part with a specific inclination between 65° to 89.99° with respect to the horizontal plane of the construction;
• a lower skirting board profile (7) that includes a removable exterior cover profile (12), which joins and covers both sides of the base supports (10).
This allows the solar panel (2) to be dismantled and access to the wiring (13) when the exterior cover (12) is removed.

4. Inclined railing with energy-generating solar panels, according to any of claims 1 to 2, **characterised by** the inclusion of a handrail (5) manufactured using an upper profile (5A) with a substantially round section with a groove (17) where the solar panels (2) fit, and eventually where a lower profile of the handrail (5B) fixed to the inclined pilasters (3) also fits, in such a way that the handrail (5) is ergonomic regardless of the inclination of the solar panels (2).

5. Inclined railing with energy-generating solar panels, according to any of claims 1 - 2, **characterised by** the inclined pilasters (3), formed with one or more of the following elements:
• curved profiles (28) with the desired inclination;
• straight profiles cut and welded (29) between them to achieve the desired inclination; or
• a single profile fixed to the base which confers the desired inclination to the profile (30).

6. Inclined railing with energy-generating solar panels, according to claim 2 or 5, **characterised by** the bases (4) comprising means for selecting the inclination with which the pilasters (3) will be fixed after the installation of the railing, consisting of one of the following elements:
• a base (4) with different slots (31) where the pilaster (3) fits with a specific inclination, and an additional tightening element (32); or
• a base with different through holes (33) where it is possible to fix the pilaster (3) with at least two pins and subsequently an additional support element (37).

7. Inclined railing with energy-generating solar panels, according to any of the previous claims, **characterised by** one or more of the solar panels (2) being bifacial photovoltaic panels (2A), suitable for generating photovoltaic energy on both sides of the panel.

8. Inclined railing with energy-generating solar panels, according to claim 7, **characterised by** the inclusion of flat elements (27) placed on the floor below the bifacial solar panel (2A), with non-slip and reflective properties, capable of increasing solar incidence on one side of said bifacial panel, increasing its productivity.

9. Inclined railing with energy-generating solar panels, according to any of the previous claims, **characterised by** the profiles of the structure (1) located in corners forming closed angles (α) from 40° to 89.99°, including the electrical wiring (13) through its interior.

10. Inclined railing with energy-generating solar panels, according to claim 9, **characterised by** the solar panels (2) having shapes adapted to the inclination and angle (α) of the structure (1) forming a corner.

11. Inclined railing with energy-generating solar panels, according to claim 9, **characterised by** the incorporation of glazing (34) adapted to the inclination and angle (α) of the structure forming a corner.

12. Inclined railing with energy-generating solar panels, according to claim 2, **characterised by** the inclusion of hybrid solar panels (2), where the structure comprises:
- a hydraulic inlet (18) for ambient temperature liquid and a hydraulic outlet (19) for hot liquid;
- for each group of panels (2), a parallel pipe (35) to the pilaster profile (3), to transport the incoming ambient temperature liquid towards a longitudinal pipe (21);
- incoming liquid connections (20) to the panel (2);
- the piping system and the photovoltaic layer (22), forming part of the panel (2), being held between the lower support profiles (9) and upper handrail (5);
- outgoing hot liquid connections (23) to panel (2);
- hot liquid conduction pipes from the outgoing liquid connection (23) to a hot liquid longitudinal pipe (36);
- longitudinal pipes (36), containing hot liquid towards the hot liquid hydraulic outlet (19); and
- a common collector (24) that conducts the wiring and tubes towards the interior of the construction.
It is possible to direct the hot water flow both from the upper part of the panel towards the lower part, and in the opposite direction.

13. Inclined railing with solar panels power generators, according to claim 12, **characterised by** hybrid solar panels (2) that
• have the same thickness across their entire surface; or
• have a greater thickness in the central part where the piping system is located, either on its front or back, than in the lower and upper area of the panel (2), where there is a smaller thickness to facilitate the fitting of the panel (2) between the lower support profiles (9) and upper handrail (5).

14. Inclined railing with energy-generating solar panels, according to any of claims 2, 5 or 6, **characterised by** the fact that each solar panel (2) is held by two inclined pilasters (3), one on each side of the panel (2), or by three inclined pilasters (3), two lateral and one central, in such a way that it is possible to place the solar panels (2) with an inclination between 30 and 85° with respect to the horizontal plane of the construction and consequently place the solar panels (2) both in a horizontal position, so that their width (a) is greater than their height (h), and in a vertical position, such that their height (h') is greater than their width (a').

15. Inclined railing with energy-generating solar panels, according to any of claims 2, 5 or 6, **characterised by** the fact that each inclined pilaster (3) is supported on a vertical post (6) located between its lower end and the handrail (5) or on at least two vertical posts (6), one located closer to the lower end and the other closer to the handrail (5), in such a way that it is possible to place the solar panels (2) with an inclination between 30 and 85° with respect to the horizontal plane of the construction and consequently place the solar panels (2) both in a horizontal position, so that their width (a) is greater than their height (h), and in a vertical position, such that their height (h') is greater than their width (a').

## Amended claims

### Amended claims in accordance with Rule 137(2) EPC.

1. Inclined railing with energy-generating solar panels comprising an inclined fixing structure (1), formed by metal profiles, aluminium or steel, fittings and joints, to which solar panels (2) are attached, wherein the structure (1) comprises:
• a plurality of separate anchors (25) fixed to the construction, where the railing structure (1) is attached and in turn the solar panels (2) are attached in an inclined manner with respect to a horizontal plane of the construction; and
• at least, one skirting board (26) formed by a set of profiles creating a hollow space inside where electrical wiring (13) runs, and possibly the hydraulic tubes, of the solar panels (2) and accessible through a cover plate (27).
**characterized in that:**
• the plurality of separate anchors (25) are in the form of separate base supports (10) anchored to the construction, provided with shims and joints (11) configured to hold the solar panel (2) at its lower part with an inclination between 65° to 89.99° with respect to a horizontal plane of the construction; and
• the lower skirting board profile (7) includes an exterior cover formed by a pair of removable exterior cover profiles (12) which join and cover both sides of the base supports (10), such that the solar panel (2) can be dismantled and the electrical wiring (13) accessed when the exterior cover (12) is removed.

2. Inclined railing with energy-generating solar panels according to claim 1, wherein one or more of the solar panels (2) are bifacial photovoltaic panels (2A) suitable for generating photovoltaic energy on both sides of the panel.

3. Inclined railing with energy-generating solar panels according to claim 2, further comprising flat elements (27) placed on the floor below the bifacial solar panel (2A), with non-slip and reflective properties, capable of increasing solar incidence on one side of said bifacial panel (2A), increasing its productivity.

4. Inclined railing with energy-generating solar panels according to any of the previous claims, wherein the profiles of the structure (1) are located in corners forming closed angles (α) from 40° to 89.99°, including the electrical wiring (13) through its interior.

5. Inclined railing with energy-generating solar panels according to claim 4, wherein the solar panels (2) have shapes adapted to the inclination and angle (α) of the structure (1) forming a corner.

6. Inclined railing with energy-generating solar panels according to claim 4, further comprising a glazing (34) adapted to the inclination and angle (α) of the structure forming a corner.
